# FASCICULE DE BREVET EUROPEEN

(11) **EP 1 586 118 B1**
(45) Date de publication et mention de la délivrance du brevet: **08.10.2008**
(21) Numéro de dépôt: 04701373.5
(22) Date de dépôt: 12.01.2004
(51) Int. Cl.: H01L 27/11

(54) **CONDENSATEUR ENTERRE ASSOCIE A UNE CELLULE SRAM**
VERGRABENER KONDENSATOR FÜR EINE SRAM-SPEICHERZELLE
EMBEDDED CAPACITOR ASSOCIATED WITH A SRAM CELL

(30) Priorité: 13.01.2003 FR 0300307
(43) Date de publication de la demande: 19.10.2005
(73) Titulaire: STMicroelectronics S.A., 92120 Montrouge (FR)
(72) Inventeur: SCHOELLKOPF, Jean-Pierre, F-38000 GRENOBLE (FR)
(74) Mandataire: de Beaumont, Michel
(86) Numéro de dépôt international: PCT/FR2004/050011
(87) Numéro de publication internationale: WO 2004/066350

(56) Documents cités:
- US-A- 5 805 497
- US-A- 5 903 036

## Description

La présente invention concerne de manière générale la formation de condensateurs dans des circuits intégrés, et en particulier la réalisation de condensateurs associés à des cellules SRAM.

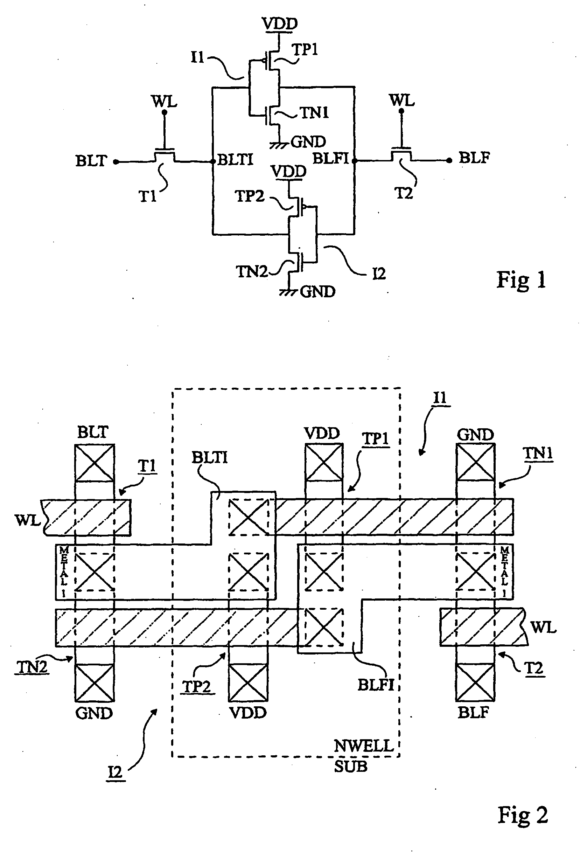

La figure 1 représente un circuit de cellule de mémoire SRAM à six transistors. La cellule comporte un point mémoire composé de deux inverseurs I1 et I2 reliés tête-bêche dont les deux entrées, respectivement BLTI, BLFI, sont reliées à des lignes de bit BLT, BLF par des transistors MOS à canal N (NMOS) T1, T2. Les grilles des transistors T1 et T2 sont reliées à une ligne de mot WL. L'inverseur I1 comporte un transistor PMOS TP1 et un transistor NMOS TN1. Les grilles des transistors TP1 et TN1 sont reliées à la borne BLTI de l'inverseur. Les drains des transistors TP1 et TN1 sont reliés et forment la borne de sortie de l'inverseur. Les sources des transistors TP1 et TN1 sont respectivement reliées à une tension d'alimentation VDD et une masse GND. L'inverseur I2 a la même structure et comporte un transistor PMOS TP2 et un transistor NMOS TN2.

La figure 2 représente une vue de dessus simplifiée d'une réalisation en technologie CMOS de la cellule SRAM de la figure 1. Pour des raisons de simplicité, les transistors à canal P et N sont représentés avec de mêmes largeurs de grille. Les transistors T1, T2, TN1 et TN2 à canal N sont réalisés dans un substrat de type P (SUB) et les transistors TP1 et TP2 à canal P sont réalisés dans un caisson de type N (NWELL). Les régions de drain des transistors TN1, T1 et TN2, T2 sont confondues. Les grilles des transistors, réalisées en silicium polycristallin, sont représentées en hachuré. Les grilles des transistors TP1, TN1, respectivement TP2, TN2 sont reliées entre elles. Les drains des transistors TP1 et TN1 sont reliés aux grilles des transistors TP2, TN2 par une ligne conductrice réalisée dans une couche métallique supérieure (METAL1) par l'intermédiaire de vias ou contacts (dont les emplacements sont représentés par des croix). Les drains des transistors TP2 et TN2 sont reliés à la grille des transistors TP1, TN1 par une ligne conductrice réalisée dans la même couche métallique (METAL1). Des vias font le contact entre les régions de source des transistors T1, T2, TN1, TN2, TP1, TP2 et des lignes métalliques non représentées reliées respectivement aux lignes BLT, BLF et aux potentiels GND, GND, VDD et VDD. Le caisson de type N est polarisé à la masse et le substrat à un potentiel prédéterminé. Pour des raisons de clarté, les tranchées d'isolation STI des transistors n'ont pas été représentées. Les tranchées STI sont de préférence l'inverse des zones actives (drains ou sources) .

Les inverseurs I1 et I2 forment une structure bistable ou point mémoire pouvant prendre deux états. Lorsque les transistors T1 et T2 sont fermés, une commande appropriée des lignes de bit BLT, BLF permet de modifier l'état du point mémoire et par là de programmer une information. Lorsque les transistors T1 et T2 sont ouverts, la cellule mémoire conserve l'information sous forme d'une charge sur les capacités de grille des transistors de l'un ou l'autre des inverseurs.

Si un rayonnement ionisant frappe la cellule 2, cela y crée des charges électriques parasites susceptibles de modifier l'état de mémorisation. Les cellules SRAM récentes étant réalisées avec des transistors MOS ayant des dimensions de plus en plus petites, la capacité de grille des transistors formant les inverseurs est de plus en plus faible et le point mémoire est de plus en plus sensible aux rayonnements ionisants, d'autant plus que le potentiel d'alimentation VDD des inverseurs est de plus en plus faible.

Pour accroître la résistance aux rayonnements ionisants d'une cellule SRAM de faible surface réalisée avec des transistors de petite dimension, il a été proposé de coupler les grilles des transistors du point mémoire à des condensateurs supplémentaires. Il se pose alors le problème de réaliser de tels condensateurs sans augmenter la surface de la cellule SRAM.

US 5 805 497 décrit un transistor MOS comprenant un condensateur.

Un objet de la présente invention est de prévoir une structure de condensateur qui puisse être disposée dans un circuit intégré sans accroître la surface du circuit.

Un objet plus particulier de la présente invention est de prévoir une telle structure permettant d'associer des condensateurs à une cellule de mémoire SRAM sans augmenter la surface de ladite cellule.

Un objet de la présente invention est de prévoir un procédé de fabrication d'un tel condensateur.

Pour atteindre, ces objets, ainsi que d'autres, la présente invention comme definie dans les revendications 1 et 6 prévoit un condensateur enterré formé par une région conductrice enrobée d'isolant formée dans une région active d'un composant du circuit intégré.

Plus particulièrement, la présente invention prévoit un condensateur dont une première électrode est constituée d'une région active fortement dopée d'un composant semiconducteur formé du côté d'une surface d'un corps semiconducteur, et dont la deuxième électrode est constituée d'une région conductrice enrobée d'isolant formée sous une et une seule des régions active et noyée dans le corps semiconducteur.

Selon un mode de réalisation de la présente invention, la région conductrice enrobée comprend un prolongement au-dessus d'une portion duquel est formée une ouverture de contact vers la deuxième électrode.

La région active fortement dopée est la région de drain ou de source d'un transistor MOS.

La présente invention vise également une cellule de mémoire SRAM comportant deux inverseurs tête-bêche dont chacun comporte deux transistors MOS de deux types de conductivité formés côte à côte dont les drains sont reliés entre eux et dont les grilles sont reliées entre elles, et comportant deux condensateurs tels que décrits précédemment dont les premières électrodes respectives sont les drains desdits transistors et dont les deuxièmes électrodes sont une même région enrobée reliée aux grilles desdits transistors par l'intermédiaire d'une ouverture de contact formée entre les deux transistors.

La présente invention vise également une cellule de mémoire DRAM comportant un transistor MOS dont la région de source est reliée à une ligne de bits, dont la grille est reliée à une ligne de mot, et comportant un condensateur tel que décrit précédemment dont la première électrode est la région de drain dudit transistor et dont la deuxième électrode est une région enrobée reliée à une ligne d'alimentation.

La présente invention vise également un circuit intégré dans lequel l'isolant enrobant la face inférieure de la région enrobée présente une constante diélectrique plus forte que l'isolant enrobant le reste de la région conductrice enrobée.

La présente invention vise également un procédé de fabrication d'un condensateur dont une première électrode est constituée d'une région active fortement dopée d'un composant semiconducteur, comprenant les étapes suivantes :
a/ former à la surface d'un substrat semiconducteur initial une région conductrice enrobée d'isolant ;
b/ faire croître par épitaxie une couche semiconductrice de manière à recouvrir le substrat initial et à enterrer la région enrobée;
c/ former ladite région active fortement dopée dans toute l'épaisseur de ladite couche semiconductrice, au-dessus d'une portion de la région conductrice enrobée.

La région active fortement dopée est une et seule des régions de drain ou de source d'un transistor MOS.

Selon un mode de réalisation de la présente invention, avant de réaliser les régions de drain et de source, une ouverture est pratiquée au-dessus d'une autre portion de la région conductrice enrobée dans ladite couche semiconductrice et dans l'isolant enrobant la région conductrice pour relier la région conductrice à une couche conductrice servant à réaliser la grille du transistor.

Selon un mode de réalisation de la présente invention, l'ouverture est pratiquée lors de l'étape de creusement des tranchées d'isolation STI dudit transistor MOS.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2, précédemment décrites, représentent respectivement un circuit et une vue de dessus simplifiée d'une cellule SRAM classique ;
les figures 3A et 3B sont des vues de dessus et en perspective d'un transistor MOS dont le drain constitue une première électrode d'un condensateur selon la présente invention ;
la figure 4 est une vue de dessus simplifiée d'une cellule SRAM associée à des condensateurs selon la présente invention ;
la figure 5 représente un circuit équivalent à la structure de la figure 4 ;
les figures 6A, 6B, 6C illustrent une étape de la fabrication de l'inverseur I1 de la cellule SRAM de la figure 4 respectivement selon une vue de dessus et selon des vues en coupe prises dans des plans B-B, C-C ;
les figures 7A à 10A, 7B à 10B et 7C à 10C représentent respectivement de mêmes vues de dessus et en coupe pour des étapes ultérieures de fabrication de l'inverseur I1 ;
la figure 10D représente une vue en coupe de l'inverseur I1 selon un plan D-D lors de l'étape illustrée par les figures 10A à 10C ; et
la figure 11 représente une vue en coupe de deux cellules DRAM selon la présente invention.

De mêmes références représentent de mêmes éléments aux figures 1 et 2 et aux figures suivantes. Seuls les éléments nécessaires à la compréhension de la présente invention ont été représentés.

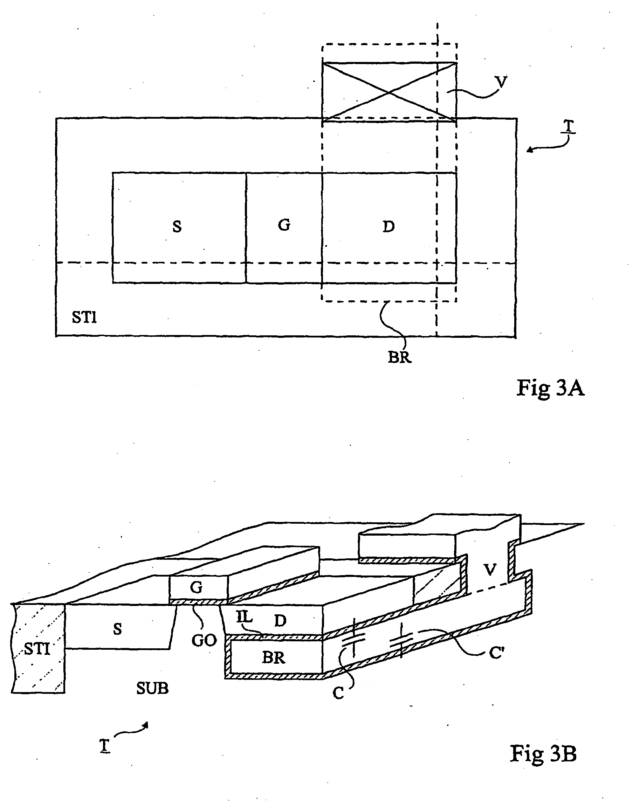

La figure 3A est une vue de dessus simplifiée d'un transistor MOS de type N, T, dont le drain constitue une première électrode d'un condensateur C selon la présente invention. La figure 3B est une vue en perspective du transistor et du condensateur de la figure 3A. En figure 3B, dans les partiels en coupe, les régions isolantes sont hachurées.

Comme l'illustrent les figures 3A et 3B, le transistor T comporte une grille G réalisée en silicium polycristallin sur une mince couche d'oxyde de grille GO à la surface d'un substrat SUB. Le transistor comporte une région de source S et une région de drain D fortement dopées formées de part et d'autre de la grille G dans la surface du substrat. Le transistor est entouré d'une tranchée d'isolation peu profonde STI formée dans la surface du substrat.

Selon la présente invention, une région conductrice BR enrobée d'isolant (IL) est formée dans la région de drain D du transistor T de telle manière qu'une portion de la région BR est séparée d'une portion en regard de la région de drain D par l'isolant IL enrobant la région conductrice BR. Aux figures 3A, 3B et aux figures suivantes, la région enrobée BR est disposée de telle manière que seule la face inférieure de la région de drain D repose sur la face supérieure d'une portion de la région enrobée BR. La présente invention vise cependant également les cas où la région de drain entoure partiellement ou complètement les faces latérales d'une portion de la région BR. Un premier condensateur C est formé entre les portions en regard du drain D et de la région BR, séparées par l'isolant enrobant la région BR. Un deuxième condensateur C' est formé entre les portions en regard de la région BR et du substrat SUB, séparées par l'isolant enrobant la région BR. Une ouverture V aux parois recouvertes d'isolant est formée au dessus d'une autre portion de la région BR. Une couche conductrice, par exemple du silicium polycristallin, remplit l'ouverture V de manière à former un contact vers la région BR.

Ainsi, selon un premier avantage de la présente invention, on réalise un condensateur dont une électrode est une régions active fortement dopée d'un composant (ici le drain d'un transistor), la surface occupée par l'ensemble de la région active et du condensateur n'étant pas supérieure à la surface de la région active.

Selon un deuxième avantage de la présente invention qui ressortira de la description ci-après d'un procédé de fabrication, la prise de contact sur la deuxième électrode du condensateur peut être effectuée en même temps que la réalisation des grilles de transistor MOS.

Selon un troisième avantage qui ressortira également de la description ci-après d'un procédé de fabrication, l'isolant entre la région active et la région conductrice sous-jacente peut être choisi indépendamment de l'isolant entre cette région conductrice et le substrat, d'où il résulte que les condensateurs C et C' peuvent être optimisés indépendamment.

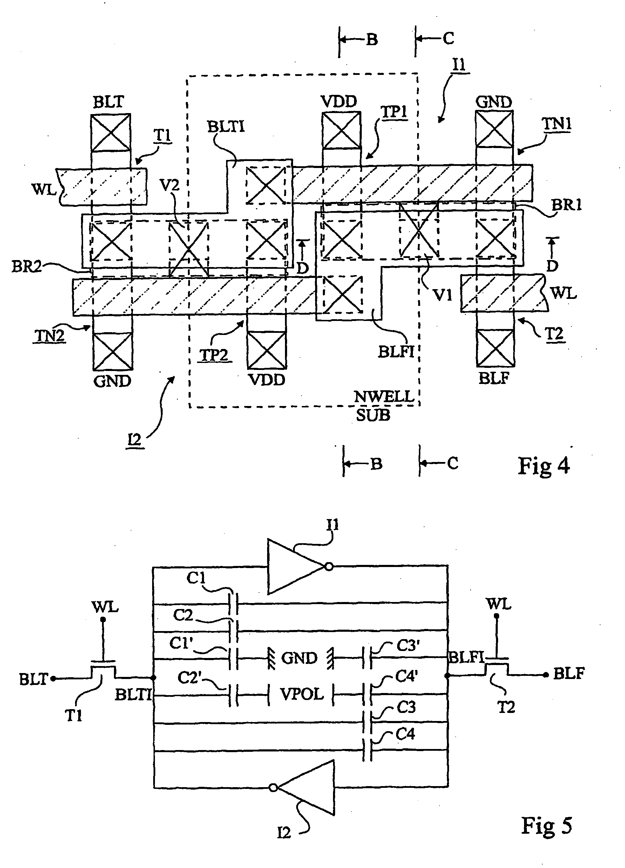

La figure 4 représente une vue de dessus simplifiée d'une cellule CMOS de mémoire SRAM à six transistors associée à des condensateurs selon la présente invention. La cellule SRAM comporte deux inverseurs I1 et I2 et deux transistors T1, T2 ayant les mêmes connexions et les mêmes dimensions qu'en figure 2. Selon un mode de réalisation préféré de la présente invention, une même région enrobée BR1 est disposée de telle manière que les régions de drain des transistors TP1 et TN1 de l'inverseur I1 reposent chacune directement sur une portion de la région enrobée BR1. En outre, une excroissance de la couche gravée de silicium polycristallin formant les grilles des transistors TP1 et TN1 est formée de manière à relier électriquement lesdites grilles à la région BR1 par l'intermédiaire d'une ouverture de contact V1. L'ouverture V1 est pratiquée entre les transistors TP1 et TN1 au dessus de la frontière entre le caisson NWELL et le substrat SUB. Comme cela est illustré par la suite en relation avec la figure 5, quatre condensateurs sont formés autour de la région enrobée BR1 reliée aux grilles des transistors TP1 et TN1 de l'inverseur I1. De même, les régions de drain des transistors TP2 et TN2 de l'inverseur I2 reposent chacune directement sur une région enrobée BR2 reliée par une ouverture V2 aux grilles des transistors TP2 et TN2, et quatre condensateurs sont formés autour de la région enrobée BR2 reliée aux grilles des transistors TP2 et TN2 de l'inverseur I2. Les huit condensateurs reliés aux grilles des transistors des inverseurs I1 et I2 permettent d'accroître la résistance de la cellule SRAM aux rayonnements ionisants.

Ce mode de réalisation préféré de l'invention tire parti du fait qu'un processus de fabrication CMOS classique impose qu'un transistor à canal P formé dans un caisson de type N, ici le transistor TP1 de l'inverseur Il, soit séparé par une distance prédéterminée minimale du plus proche transistor à canal N formé dans le substrat, ici le transistor TN1 de l'inverseur I1. La distance prédéterminée minimale dépend du processus utilisé, mais de manière avantageuse, dans un processus CMOS standard classiquement utilisé pour réaliser une cellule SRAM, la distance séparant les transistors TP1 et TN1 est suffisante pour que la précision du processus permette de former l'ouverture V1 et l'excroissance de la couche de grille sans devoir écarter les transistors TP1 et TN1. Ainsi, la surface de l'inverseur I1 couplé à des condensateurs selon la présente invention est identique à la surface d'un inverseur classique. Il en va de même pour l'inverseur I2, d'où il découle que l'invention permet de réaliser une cellule de mémoire SRAM résistante aux rayonnements ionisants qui occupe la même surface qu'une cellule de mémoire SRAM classique non résistante aux rayonnements.

La figure 5 représente un circuit équivalent à la structure de la figure 4 et indique en particulier les connexions des condensateurs selon la présente invention. Les inverseurs I1 et I2 sont représentés sous forme de blocs. Un condensateur C1, formé entre le drain D du transistor TP1 et la région BR1 reliée à la grille du transistor TP1, couple l'entrée et la sortie de l'inverseur I1. De même, un condensateur C2 formé entre le drain du transistor TN1 et la région BR1 couple l'entrée et la sortie de l'inverseur I1. Un condensateur C1'. formé entre la région conductrice BR1 et le caisson NWELL couple l'entrée de l'inverseur I1 à la masse GND. Un condensateur C2', formé entre la région BR1 et le substrat, couple l'entrée de l'inverseur I1 à un potentiel de polarisation VPOL du substrat SUB. De manière semblable, des condensateurs C3, C4, respectivement formés entre les drains des transistors TP2, TN2 et la région BR2, couplent l'entrée et la sortie de l'inverseur I2. Un condensateur C3' selon l'invention, formé entre la région conductrice BR2 et le caisson NWELL, couple l'entrée de l'inverseur I2 à la masse GND. Un condensateur C4' selon l'invention, formé entre la région BR2 et le substrat, couple l'entrée de l'inverseur I2 au potentiel VPOL.

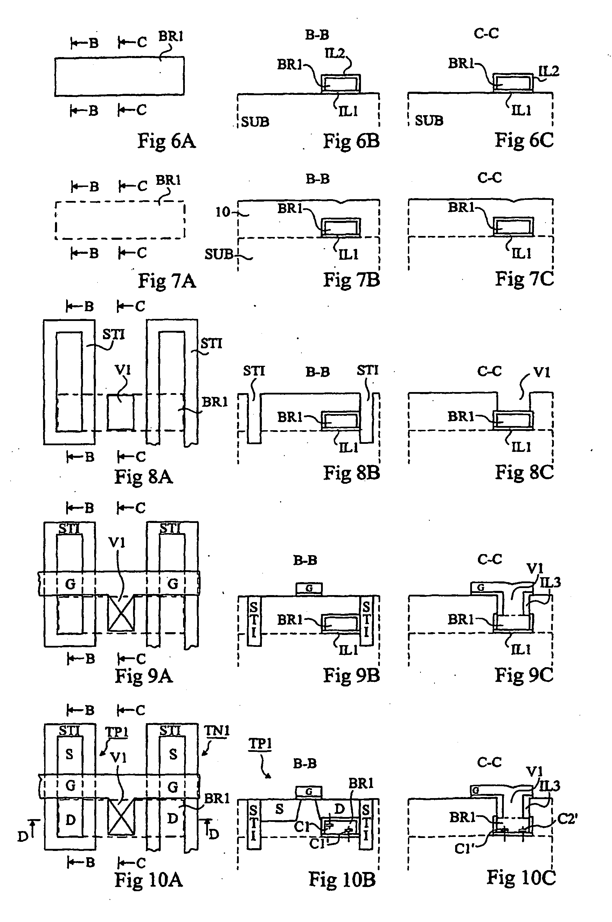

Les figures 6 à 10 suivantes illustrent des étapes de fabrication de condensateurs selon un mode de réalisation de la présente invention. A titre d'exemple, les figures 6 à 10 suivantes illustrent des étapes de fabrication des condensateurs associés à l'inverseur I1 de la cellule SRAM de la figure 4.

Les figures 6A, 6B et 6C représentent respectivement une vue de dessus et des vues en coupe selon des plans B-B, C-C de l'inverseur I1 après les premières étapes d'un procédé de fabrication selon la présente invention. Le plan B-B coupe le transistor TP1 dans le sens de sa longueur. La source et le drain du transistor TP1 sont respectivement à gauche et à droite de la vue en coupe selon le plan B-B.

Lors de premières étapes, une couche mince isolante IL1 est déposée à la surface d'un substrat initial SUB de silicium monocristallin faiblement dopé de type P. Une couche d'un conducteur tel que du silicium polycristallin est déposée par-dessus la couche IL1, et les deux couches déposées sont gravées au moyen d'un premier masque de manière à définir la région BR1, ici selon un rectangle dont une première extrémité (coupe B-B) sera située sous le drain du transistor TP1, et dont l'autre extrémité sera située sous le drain du transistor TN1. On procède ensuite à une étape d'oxydation thermique suivie d'une gravure isotrope de l'oxyde de telle sorte qu'il reste une couche mince IL2 d'oxyde de silicium à la surface et sur les côtés de la région de silicium polycristallin et que l'oxyde de silicium est éliminé à la surface du substrat SUB.

Les figures 7A, 7B et 7C représentent respectivement les mêmes vues que les figures 6A, 6B et 6C lors d'une étape ultérieure, après avoir fait croître par épitaxie une couche de silicium monocristallin 10 à partir du substrat initial, de manière à recouvrir le substrat initial et à enterrer complètement la région BR1 par croissance latérale. Le type et le niveau de dopage de la couche épitaxiale 10 sont choisis pour optimiser les transistors MOS à former et ne sont pas nécessairement identiques à ceux du substrat initial. L'ensemble du substrat initial et de la couche épitaxiale 10 constitue alors un substrat ou corps semiconducteur dans lequel est noyée la région conductrice enrobée d'isolant BR1.

Les figures 8A, 8B et 8C représentent respectivement les mêmes vues que les figures 7A, 7B et 7C après avoir :
planarisé la surface de la couche de silicium monocristallin 10 ;
formé des caissons NWELL (non représentés) ; et
formé dans la couche 10 et le substrat des tranchées peu profondes (STI) destinées à être remplies d'isolant pour isoler latéralement les transistors MOS de l'inverseur.

Pour simplifier les figures, les tranchées d'isolation sont dans les présentes figures représentées plus étroites qu'elles ne le sont en pratique. Selon la présente invention, le masque utilisé de manière classique pour creuser les tranchées d'isolation est également utilisé pour creuser une ouverture V1 située sensiblement au centre de la région BR1 (coupe C-C). En raison de la sélectivité de gravure entre l'oxyde de silicium et le silicium, au dessus de la région BR1, la gravure s'arrête naturellement sur l'oxyde enrobant cette région BR1.

Les figures 9A, 9B et 9C représentent respectivement les mêmes vues que les figures 8A, 8B et 8C après avoir :
rempli les tranchées STI et l'ouverture V1 d'un isolant tel que de l'oxyde de silicium ;
recouvert d'une couche d'oxyde de grille le silicium monocristallin de la surface du circuit ;
retiré l'isolant se trouvant au centre de l'ouverture V1 sur la surface supérieure de la région conductrice BR1, tout en laissant en place un isolant IL3 sur les parois verticales de l'ouverture V1 ;
déposé à la surface du circuit une couche de silicium polycristallin de manière à former la couche de grille des transistors et à remplir l'ouverture V1 jusqu'à former un contact électrique avec la région enterrée BR1 ; et
gravé le silicium polycristallin puis l'oxyde de grille de manière à définir les grilles G des transistors MOS TN1, TP1 de l'inverseur, reliées entre elles. Selon l'invention, les grilles des transistors TN1, TP1 sont également reliées à la région BR1 par l'ouverture V1.

Les figures 10A, 10B et 10C représentent respectivement les mêmes vues que les figures 9A, 9B et 9C après formation des régions de drain D et de source S des transistors PMOS TP1 et NOS TN1. Selon la présente invention, le dopage des régions de drain D des transistors est tel que les régions de drain s'étendent en profondeur jusqu'à l'isolant IL1 recouvrant la face supérieure de la région conductrice BR1. Diverses variantes de réalisation classique de régions de drain et de source pourront être utilisées, par exemple pour former des structures à espaceurs de type LDD.

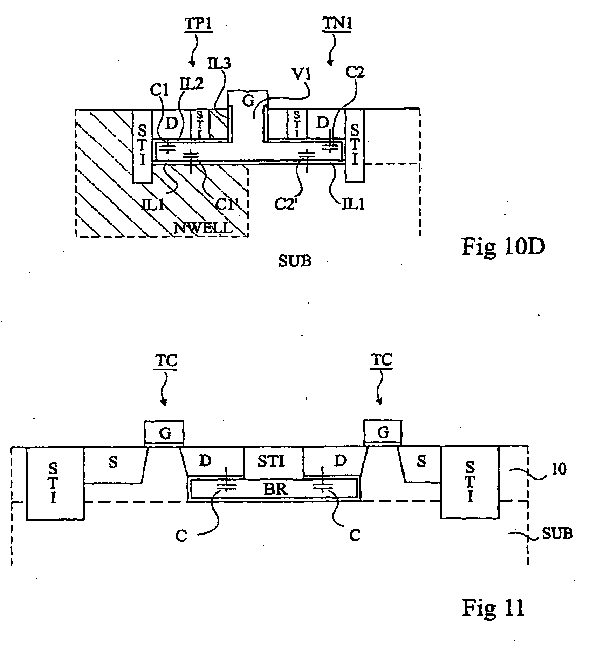

La figure 10D représente une vue en coupe de l'inverseur I1 des figures 10A à 10C selon un plan D-D coupant la région conductrice enterrée BR1 sur toute sa longueur et coupant les régions de drain des transistors TP1, TN1. La figure 10D représente en outre le caisson NWELL non représenté aux figures 6 à 9 pour des raisons de clarté.

Le procédé de fabrication illustré aux figures 6 à 10 est particulièrement simple à mettre en oeuvre. De plus, ce procédé ne demande que deux masques spécifiques (décrits en relation avec les figures 6 et 9) ce qui le rend particulièrement peu coûteux.

Bien entendu, la présente invention est susceptible de diverses variantes et modifications qui apparaîtront à l'homme de l'art. En particulier, le type et l'épaisseur de l'isolant mince (IL1) disposé entre la surface inférieure des régions conductrices et le substrat initial peut être choisi de manière appropriée pour optimiser la valeur des condensateurs couplant les régions conductrices enrobées BR au caisson NWELL et au substrat. A titre d'exemple, l'isolant peut être un oxynitride ayant une épaisseur de 1 à 2 nm, du AL₂O₃ ayant une épaisseur de 1 à 3 nm ou du Ta₂O₅ ayant une épaisseur de 2 à 3 nm.

La présente invention a été décrite en relation avec un procédé de fabrication particulier d'une structure particulière comportant des régions conductrices enrobées enterrées, mais l'homme du métier adaptera sans difficulté la présente invention à des procédés de fabrication permettant de réaliser une structure comportant des régions conductrices enrobées enterrées équivalentes.

La figure 11 représente à titre d'exemple une vue en coupe de deux cellules DRAM selon la présente invention. Chaque cellule DRAM comprend un transistor de commande TC entouré latéralement de tranchées STI dont la source S est reliée à une ligne de bits non représentée, dont la grille G est reliée à une ligne de mot non représentée, et dont le drain D repose directement sur une région conductrice enrobée BR. La région conductrice enrobée est reliée à une ligne d'alimentation non représentée. Le condensateur C formé entre les surfaces en regard du drain D et de la région BR constitue le point mémoire de la cellule DRAM. L'homme du métier notera que la mise en commun de la région enrobée BR entre les deux cellules DRAM permet un gain de surface.

La présente invention s'adaptera également sans difficulté à un ou plusieurs condensateurs couplant d'autres régions actives appartenant à d'autres types de composants d'un circuit intégré reposant directement sur la région enrobée. La présente invention s'adaptera notamment sans difficulté à des condensateurs couplant plusieurs régions actives de plusieurs composants dont chacune repose directement sur une portion d'une même région enterrée.

## Revendications

1. Condensateur dont une première électrode est constituée de la région de drain (D) ou de source d'un transistor MOS (T) formé du côté d'une surface d'un corps semiconducteur, dans laquelle la deuxième électrode est constituée d'une région conductrice (BR) enrobée d'isolant (IL) formée sous une et une seule des régions de drain ou de source et noyée dans le corps semiconducteur.

2. Condensateur selon la revendication 1, dans lequel la région conductrice enrobée comprend un prolongement au dessus d'une portion duquel est formée une ouverture (V) de contact vers la deuxième électrode.

3. Cellule de mémoire SRAM comportant deux inverseurs tête-bêche (I1 ; I2) dont chacun comporte deux transistors MOS de deux types de conductivité (TN1, TP1 ; TN2, TP2) formés côte à côte dont les drains sont reliés entre eux et dont les grilles sont reliées entre elles, et comportant deux condensateurs (C1, C2) selon la revendication 2 dont les premières électrodes respectives sont les drains (D) desdits transistors et dont les deuxièmes électrodes sont une même région enrobée (BR1 ; BR2) reliée aux grilles (G) desdits transistors par l'intermédiaire d'une ouverture de contact (V1, V2) formée entre les deux transistors.

4. Cellule de mémoire DRAM comportant un transistor MOS (TC) dont la région de source (S) est reliée à une ligne de bits, dont la grille (G) est reliée à une ligne de mot, et comportant un condensateur (C) selon la revendication 2 dont la première électrode est la région de drain (D) dudit transistor et dont la deuxième électrode est une région enrobée (BR) reliée à une ligne d'alimentation.

5. Circuit intégré comportant un condensateur conforme à la revendication 1 ou 2 ou comportant une cellule de mémoire conforme à la revendication 3 ou 4, dans lequel l'isolant (IL1) enrobant la face inférieure de la région enrobée (BR1) présente une constante diélectrique plus forte que l'isolant (IL2) enrobant le reste de la région conductrice enrobée.

6. Procédé de fabrication d'un condensateur dont une première électrode est constituée d'une région active fortement dopée (D) d'un composant semiconducteur, comprenant les étapes suivantes :
a/ former à la surface d'un substrat semiconducteur initial (SUB) une région conductrice enrobée d'isolant (BR1) ;
b/ faire croître par épitaxie une couche semiconductrice (10) de manière à recouvrir le substrat initial et à enterrer la région enrobée (BR1) ;
c/ former ladite région active fortement dopée (D) dans toute l'épaisseur de ladite couche semiconductrice (10), au dessus d'une portion de la région conductrice enrobée (BR1),
la région active fortement dopée étant une et une seule des régions de drain (D) ou de source d'un transistor MOS (TP1, TN1).

7. Procédé selon la revendication 6, dans lequel avant de réaliser les régions de drain et de source, une ouverture (V1) est pratiquée au dessus d'une autre portion de la région conductrice enrobée (BR1) dans ladite couche semiconductrice (10) et dans l'isolant (IL2) enrobant la région conductrice (BR1) pour relier la région conductrice (BR1) à une couche conductrice servant à réaliser la grille (G) du transistor (TP1, TN1).

8. Procédé selon la revendication 7, dans lequel l'ouverture (V1) est pratiquée lors de l'étape de creusement des tranchées d'isolation STI dudit transistor MOS.

## Claims

1. A capacitor having a first electrode formed of the drain (D) or source region of a MOS transistor (T) formed on the side of a surface of a semiconductor bulk, wherein the second electrode formed of a conductive region (BR) coated with an insulator (IL) formed under one and only one of the drain or source regions and embedded in the semiconductor bulk.

2. The capacitor of claim 1, wherein the coated conductive region comprises an extension above a portion of which is formed a contact opening (V) towards the second electrode.

3. An SRAM cell comprising two inverters (11; 12) head-to-tail, each of which comprises two MOS transistors of two conductivity types (TN1, TP1; TN2, TP2) formed side by side, having their drains connected to each other and having their gates connected to each other, and comprising two capacitors (C1, C2) of claim 2, the respective first electrodes of which are the drains (D) of said transistors and the second electrodes of which are a same coated region (BR1; BR2) connected to the gates (G) of said transistors via a contact opening (V1, V2) formed between the two transistors.

4. A DRAM cell comprising a MOS transistor (TC) having its source region (S) connected to a bit line, having its gate (G) connected to a word line, and comprising a capacitor (C) of claim 2, the first electrode of which is the drain region (D) of said transistor and the second electrode of which is a coated region (BR) connected to a supply line.

5. An integrated circuit comprising a capacitor according to claim 1 or 2 comprising a memory cell according to claim 3 or 4, wherein the insulator (IL1) coating the lower surface of the coated region (BR1) exhibits a stronger dielectric constant than the insulator (IL2) coating the rest of the coated conductive region.

6. A method for manufacturing a capacitor having a first electrode formed of a heavily-doped active region (D) of a semiconductor component, comprising the steps of:
a/ forming at the surface of an initial semiconductor substrate (SUB) a conductive region (BR1) coated with an insulator;
b/ growing by epitaxy a semiconductor layer (10) to cover the initial substrate and bury the coated region (BR1);
c/ forming said heavily-doped active region (D) across the entire thickness of said semiconductor layer (10), above a portion of the coated conductive region (BR1),
the heavily-doped active region is one and only one of the drain (D) and source regions of a MOS transistor (TP1, TN1).

7. The method of claim 6, wherein, before forming the drain and source regions, an opening (V1) is made above another portion of the coated conductive region (BR1) in said semiconductor layer (10) and in the insulator (IL2) coating the conductive region (BR1) to connect the conductive region (BR1) to a conductive layer used to form the gate (G) of the transistor (TP1, TN1).

8. The method of claim 7, wherein the opening (V1) is made at the step of digging the STI insulation trenches of said MOS transistor.

## Patentansprüche

1. Ein Kondensator, der eine erste Elektrode besitzt, die gebildet ist aus der Drain (D) oder Source-Region von einem MOS Transistor (T) der gebildet ist auf der Seite von einer Oberfläche von einem Halbleiterkörper, wobei die zweite Elektrode gebildet ist aus einer leitenden Region (BR) die mit einem Isolator (IL) beschichtet ist, der gebildet ist unter einer und nur einer von den Drain- oder Source-Regionen und in dem Halbleiterkörper eingebettet ist.

2. Kondensator nach Anspruch 1, wobei die beschichtete leitende Region eine Erweiterung besitzt oberhalb eines Teils aus dem eine Kontaktöffnung (V) hin zu der zweiten Elektrode gebildet ist.

3. Eine SRAM Zelle, die zwei Inverter (I1; I2) verkehrt herum bzw. entgegengesetzt aufweist, von denen jeder zwei MOS Transistoren von zwei Leitfähigkeitstypen (TN1, TP1; TN2, TP2) aufweist, die Seite an Seite gebildet sind, deren Drains miteinander verbunden sind, und deren Gatter bzw. Gates miteinander verbunden sind und die zwei Kondensatoren (C1, C2) nach Anspruch 2 aufweisen, wobei die entsprechenden ersten Elektroden davon die Drains (D) von den Transistoren sind und die zweiten Elektroden davon eine gleiche beschichtete Region (BR1; BR2) sind, die mit den Gattern (G) von den Transistoren über eine Kontaktöffnung (V1, V2) verbunden sind, die zwischen den zwei Transistoren gebildet ist.

4. Eine DRAM Zelle, die einen MOS Transistor (TC) aufweist, dessen Source Region (S) mit einer Bit-Leitung verbunden ist, dessen Gatter (G) mit einer Wort-Leitung verbunden ist, und die einen Kondensator (C) nach Anspruch 2 aufweist, von dem die erste Elektrode, die Drain-Region (D) von dem Transistor ist und von dem die zweite Elektrode eine beschichtete Region (BR) ist, die mit einer Versorgungsleitung verbunden ist.

5. Eine integrierte Schaltung, die einen Kondensator gemäß Anspruch 1 oder 2 aufweist, die eine Speicherzelle gemäß Anspruch 3 oder 4 aufweist, wobei der Isolator (IL1) der die untere Oberfläche von der beschichteten Region (BR1) beschichtet bzw. überzieht, eine stärkere dielektrische Konstante zeigt, als der Isolator (IL2) der den Rest von der beschichteten leitenden Region überzieht.

6. Ein Verfahren zum Herstellen eines Kondensators, der eine erste Elektrode besitzt, die aus einer stark dotierten aktiven Region (D) von einer Halbleiterkomponente gebildet ist, wobei das Verfahren die folgenden Schritte aufweist:
a/ Bilden an der Oberfläche von einem anfänglichen Halbleitersubstrat (SUB), einer leitenden Region (BR1), die mit einem Isolator beschichtet ist;
b/ Aufwachsen durch Epitaxie einer Halbleiterschicht (10), um das anfängliche Substrat abzudecken und die beschichtete Region (BR1) zu begraben;
c/ Bilden der stark dotierten aktiven Region (D) über die gesamte Dicke von der Halbleiterschicht (10) und zwar oberhalb eines Teils von der beschichteten leitenden Region (BR1),
wobei die stark dotierte aktive Region eine und nur eine von den Drain-(D) und Source-Regionen von einem MOS Transistor (TP1, TN1) ist.

7. Verfahren nach Anspruch 6, wobei, vor dem Bilden der Drain- und Source-Regionen eine Öffnung (V1) hergestellt wird, über einen anderen Teil der beschichteten leitenden Region (BR1) in der Halbleiterschicht (10) und in dem Isolator (IL2) der die leitende Region (BR1) beschichtet bzw. überzieht, um die leitende Region (BR1) mit einer leitenden Schicht zu verbinden, die genutzt wird zum Bilden des Gatters (G) von dem Transistor (TP1, TN1).

8. Verfahren nach Anspruch 7, wobei die Öffnung (V1) hergestellt wird bei dem Schritt des Grabens der STI Isolationsgräben von dem MOS Transistor.
